# EUROPÄISCHE PATENTSCHRIFT

(11) **EP 2 575 255 B1**
(45) Veröffentlichungstag und Bekanntmachung des Hinweises auf die Patenterteilung: **09.04.2014**
(21) Anmeldenummer: 12182959.2
(22) Anmeldetag: 04.09.2012
(51) Int. Cl.: H03K 17/0812, G01K 7/01, G01K 7/34, H03K 17/08

(54) **Verfahren und Einrichtung zur Ermittlung der Temperatur eines Halbleiterschalters**
Method and device for determining the temperature of a semiconductor switch
Procédé et dispositif destinés à la détermination de la température d'un circuit semi-conducteur

(30) Priorität: 29.09.2011 DE 102011083679
(43) Veröffentlichungstag der Anmeldung: 03.04.2013
(73) Patentinhaber: SEMIKRON Elektronik GmbH & Co. KG, 90431 Nürnberg (DE)
(72) Erfinder: Schuler, Stefan, 91052 Erlangen (DE)

(56) Entgegenhaltungen:
- EP-A1- 1 947 433
- DE-A1-102008 063 806

## Beschreibung

Die Erfindung betrifft ein Verfahren und Einrichtung zur Ermittlung der Temperatur eines Halbleiterschalters.

Halbleiterschalter werden unter anderem z.B. zum Gleichrichten und Wechselrichten von elektrischen Spannungen und Strömen verwendet, wobei in der Regel mehrere Halbleiterschalter zur Realisierung eines Stromrichters elektrisch miteinander verbunden werden. Die Halbleiterschalter sind dabei in der Regel auf einem Substrat angeordnet, das wiederum direkt oder indirekt mit einem Kühlkörper verbunden ist.

Beim Betrieb eines Halbleiterschalters, wie z.B. eines IGBT (Insulated Gate Bipolar Transistor) oder eines MOSFET (Metal Oxide Semiconductor Field Effect Transistor), fällt beim Ein- und Ausschalten des Halbleiterschalters im Halbleiterschalter Verlustenergie in Form von Wärme an, die zu einer Erwärmung des Halbleiterschalters führt. Die Verlustenergie fällt dabei im Wesentlichen an der sogenannten Sperrschicht des Halbleiterschalters an und führt zu deren Temperaturerhöhung. Die Verlustenergie hängt dabei im Wesentlichen von der Frequenz mit der der Halbleiterschalter ein- und ausgeschaltet wird, sowie den durch ihn im Betrieb fließenden elektrischen Ströme und der über ihm anliegenden Spannung ab.

Überschreitet im Betrieb des Halbleiterschalters die Temperatur des Halbleiterschalters, insbesondere dessen Sperrschichttemperatur, einen zulässigen Grenzwert, z.B. infolge einer dynamischen oder stationären Überlastung, kann dies zu Fehlfunktionen und im Extremfall zur Zerstörung des Halbleiterschalters führen.

Um dies zu verhindern ist es aus dem Stand der Technik bekannt in der Nähe von auf einem Substrat angeordneten Halbleiterschaltern einen Temperatursensor anzubringen und die Temperatur des Substrats zu messen, an das die Halbleiterschalter ihre Verlustenergie abgeben und das sich Infolge erwärmt. Überschreitet die gemessene Temperatur des Substrats einen voreingestellten Grenzwert, dann werden die Halbleiterschalter abgeschaltet. In Folge der Wärmezeitkonstanten und der endlichen Wärmeleitfähigkeit des Substrats, folgt die Temperatur des Substrats nur relativ träge der Temperatur des Halbleiterschalters und insbesondere der Temperatur der Sperrschicht des Halbleiterschalters. Nachteilig bei einem solchen Vorgehen ist, dass, da die Temperatur des Substrats und nicht die Temperatur der Halbleiterschalter gemessen wird, schnelle Temperaturhöhungen der Halbleiterschalter, welche z.B. im Falle von dynamischem Lastwechsel auftreten können, nicht erfasst werden und es somit trotz der Überwachung der Temperatur des Substrats zu Fehlfunktionen oder zur Zerstörung der Halbleiterschalter infolge zu hoher Temperaturen der Halbleiterschalter kommen kann. Ein Verfahren ohne Temperatursensor ist in DE 10 2008 063 806 A1 offenbart.

Häufig müssen, um die notwendige Spannungsfestigkeit oder Stromtragefähigkeit zu erzielen, mehrere Halbleiterschalter zur Realisierung eines elektrischen Ventils elektrisch in Reihe und/oder parallel geschaltet werden. Um möglichst kleine Einschaltverzugszeiten zwischen den Halbleiterschaltern eines elektrischen Ventils zu ermöglichen, sind aus dem Stand der Technik Halbleiterschalter, wie z.B. IGBTs oder MOSFETs bekannt, die einen in den Halbleiterschalter integrierten elektrischen Gatewiderstand aufweisen. Bei diesen Halbleiterschaltern wird durch das Aufbringen einer zusätzlichen dotierten Halbleiterschicht zu den ohnehin vorhandenen Schichten, welche den funktionalen Kern des Halbleiterschalters bilden, ein elektrischer ohmscher Gatewiderstand erzeugt, welcher in der Regel einen Wert von einigen Ohm aufweist. Zur Realisierung dieses in den Halbleiterschalter integrierten Gatewiderstands wird z.B. Silan (SiH4) auf einem Isolator (Si02) abgeschieden. Das dabei in einer Schicht aufgewachsene Polysilizium wird anschließend dotiert. Anschließend wird auf die dotierte Polysiliziumschicht eine Metallisierung aufgebracht, die den von außen zugänglichen Gatewiderstandsanschluss des Halbleiterschalters bildet.

Es ist Ausgabe der Erfindung ein Verfahren und eine Vorrichtung zur Ermittlung der Temperatur eines Halbleiterschalters zu schaffen, das eine hoch dynamische Ermittlung der Temperatur des Halbleiterschalters ermöglicht.

Diese Aufgabe wird gelöst durch ein Verfahren zur Ermittlung der Temperatur eines Halbleiterschalters, der einen integrierten elektrischen Gatewiderstand aufweist, mit folgenden Verfahrensschritten:
- Einschalten des Halbleiterschalters durch Erhöhen der Gate-Emitter-Spannung des Halbleiterschalters über einen mit dem Gatewiderstandsanschluss des Halbleiterschalters verbundenen externen elektrischen Widerstand,
- Ermittlung der Zeitdauer, die die Gate-Emitter-Spannung während der Erhöhung der Gate-Emitter-Spannung des Halbleiterschalters benötigt um von einer ersten Spannung auf eine zweite Spannung anzusteigen und
- Ermittlung der Temperatur des Halbleiterschalters anhand der ermittelten Zeitdauer.

Weiterhin wird diese Aufgabe gelöst durch eine Einrichtung zur Ermittlung der Temperatur eines Halbleiterschalters, der einen integrierten elektrischen Gatewiderstand aufweist, umfassend
- eine Ansteuerschaltung, die zum Einschalten des Halbleiterschalters durch Erhöhen der Gate-Emitter-Spannung des Halbleiterschalters über einen mit dem Gatewiderstandsanschluss des Halbleiterschalters verbundenen externen elektrischen Widerstand ausgebildet ist,
- eine Zeitdauerermittlungseinheit, die zur Ermittlung der Zeitdauer, die die Gate-Emitter-Spannung während der Erhöhung der Gate-Emitter-Spannung des Halbleiterschalters benötigt um von einer ersten Spannung auf eine zweite Spannung anzusteigen, ausgebildet ist und
- eine Temperaturermittlungseinheit, die zur Ermittlung der Temperatur des Halbleiterschalters anhand der ermittelten Zeitdauer ausgebildet ist.

Vorteilhafte Ausbildungen der Erfindung ergeben sich aus den abhängigen Ansprüchen. Vorteilhafte Ausbildungen des Verfahrens ergeben sich analog zu vorteilhaften Ausbildungen der Einrichtung und umgekehrt.

Weiterhin erweist sich als vorteilhaft, wenn ein Ausschalten des Halbleiters, wenn die ermittelte Temperatur des Halbleiterschalters einen Temperaturgrenzwert erreicht oder überschreitet, erfolgt. Hierdurch kann zuverlässig eine Fehlfunktion oder eine Zerstörung des Halbleiterschalters infolge einer zu hohen Temperatur des Halbleiterschalters vermieden werden.

Ferner erweist sich als vorteilhaft, wenn die zweite Spannung unterhalb der Schwellspannung des Halbleiterschalters liegt. Wenn die zweite Spannung unterhalb der sogenannten Schwellspannung des Halbleiterschalters, d.h. unterhalb der Spannungsschwelle liegt, bei der ein merklicher Kollektorstrom fließt, d.h. der Halbleiterschalter anfängt in den leitenden (eingeschalteten) Zustand überzugehen, ist sichergestellt, dass die Ermittlung der Zeitdauer zur Ermittlung der Temperatur des Halbleiterschalters unterhalb des sogenannten Miller-Plateaus stattfindet und die Rückwirkung der Kollektor-Gate-Kapazität auf den Verlauf der Gate-Emitter-Spannung keinen Einfluss auf die Ermittlung der Zeitdauer hat. Hierdurch wird eine besonders genaue Temperaturermittlung der Temperatur des Halbleiterschalters ermöglicht.

Weiterhin erweist sich als vorteilhaft, wenn der Halbleiterschalter als IGBT oder MOSFET ausgebildet ist, da diese handelsübliche Halbleiterschalter darstellen.

Ferner erweist sich eine Schaltungsanordnung mit einer erfindungsgemäßen Einrichtung, wobei die Schaltungsanordnung einen Halbleiterschalter aufweist, der einen integrierten elektrischen Gatewiderstand aufweist, wobei die Ansteuerschaltung der Einrichtung über den externen elektrischen Widerstand mit dem Gatewiderstandsanschluss des Halbleiterschalters elektrisch verbunden ist, wobei die Zeitdauerermittlungseinheit mit dem Gatewiderstandsanschluss des Halbleiterschalters elektrisch verbunden ist, als vorteilhaft.

Ein Ausführungsbeispiel der Erfindung ist in den Figuren dargestellt und wird im Folgenden näher erläutert. Dabei zeigen:
- FIG 1: eine erfindungsgemäße Einrichtung zur Ermittlung der Temperatur eines Halbleiterschalters, der einen integrierten elektrischen Gatewiderstand aufweist.
- FIG 2: Verlauf der Gate-Emitter-Spannung U_{GE} des Halbleiterschalters beim Einschalten des Halbleiterschalters
- FIG 3: Temperaturkennlinie des Halbleiterschalters

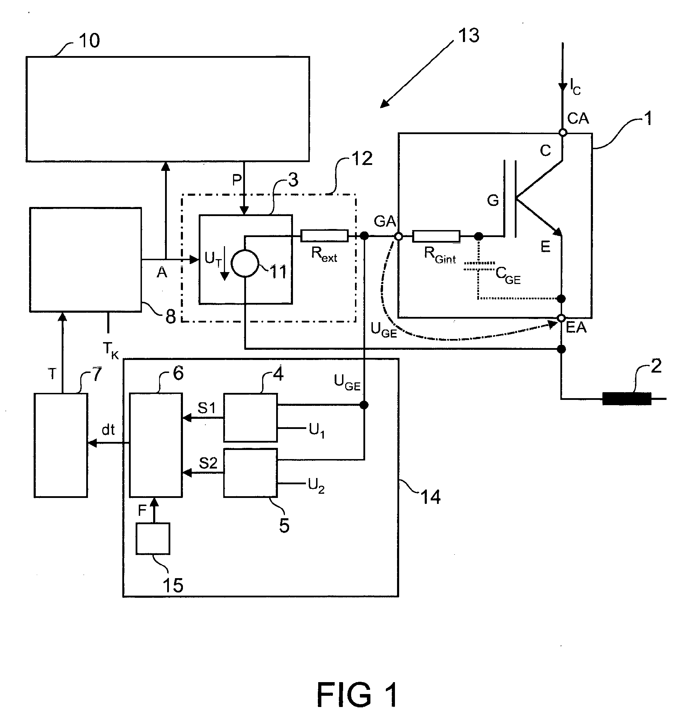

In FIG 1 ist in Form eines elektrischen Blockschaltbilds eine erfindungsgemäße Einrichtung 13 zur Ermittlung der Temperatur T eines Halbleiterschalters 1, der einen in den Halbleiterschalter 1 integrierten elektrischen Gatewiderstand R_{Gint} aufweist, dargestellt. Der Halbleiterschalter 1 ist im Rahmen des Ausführungsbeispiels als IGBT ausgebildet und weist den von außerhalb des Halbleiterschalters 1 zugänglichen zum elektrischen Anschluss des Halbleiterschalters 1 mit einem externen elektrischen Bauelement dienenden Gatewiderstandsanschluss GA auf. Mittels des Kollektoranschlusses CA kann der Kollektor C des Halbleiterschalters 1 mit der Außenwelt elektrisch verbunden werden und mittels des Emitteranschlusses EA kann der Emitter E des Halbleiterschalters 1 mit der Außenwelt elektrisch verbunden werden, wobei im Rahmen des Ausführungsbeispiels der Emitter E mit einer Last 2 elektrisch verbunden ist. Der aus dem Gate G, Emitter E, und Kollektor C bestehende Kern des Halbleiterschalters ist in FIG 1 in Form des elektrischen Symbols für einen IGBT dargestellt. Der Halbleiterschalter 1 weist einen in den Halbleiterschalter 1 integrierten elektrischen ohmschen Gatewiderstand R_{Gint} auf, der elektrisch zwischen Gatewiderstandsanschluss GA und dem Gate G geschalten ist. Der Gatewiderstandsanschluss GA ist über den Gatewiderstand R_{Gint} mit dem Gate G des Halbleiterschalter 1 elektrisch verbunden. Wie schon eingangs bei der Erläuterung des Stands der Technik beschrieben, ist der Halbleiterschalter 1, der den integrierten Gatewiderstand R_{Gint} äufweist, Stand der Technik. Bei diesen Halbleiterschaltern wird durch das Aufbringen einer zusätzlichen dotierten Halbleiterschicht auf die ohnehin vorhandenen Schichten, welche den funktionalen Kern des Halbleiterschalters bilden, ein elektrischer ohmscher Gatewiderstand erzeugt, welcher in der Regel einen Wert von einigen Ohm (z.B. 10 Ohm) aufweist.

Zwischen dem Gate G und dem Emitter E ist weiterhin die parasitäre Gate-Emitter-Kapazität C_{GE} wirksam.

Überschreitet die Gate-Emitter-Spannung U_{GE} des Halbleiterschalters 1 die sogenannte Schwellspannung U_{S} des Halbleiterschalters 1, dann sinkt der elektrische Widerstand zwischen Kollektor K und Emitter E des Halbleiterschalters 1 stark und der Kollektorstrom I_{C} beginnt durch den Halbleiterschalter 1 von Kollektor zum Emitter und von dort zur Last 2 zu fließen. Unter der Gate-Emitter-Spannung U_{GE} eines Halbleiterschalters wird dabei im Rahmen der vorliegenden Erfindung die elektrische Spannung des Gatewiderstandsanschlusses GA im Bezug zum Emitteranschluss EA des Halbleiterschalters verstanden (siehe FIG 1). Bei weiterer Erhöhung der Gate-Emitter-Spannung U_{GE} sinkt der elektrische Widerstand zwischen Kollektor und Emitter auf ein Minimum. Der Halbleiterschalter 1 ist dann im eingeschalteten Zustand.

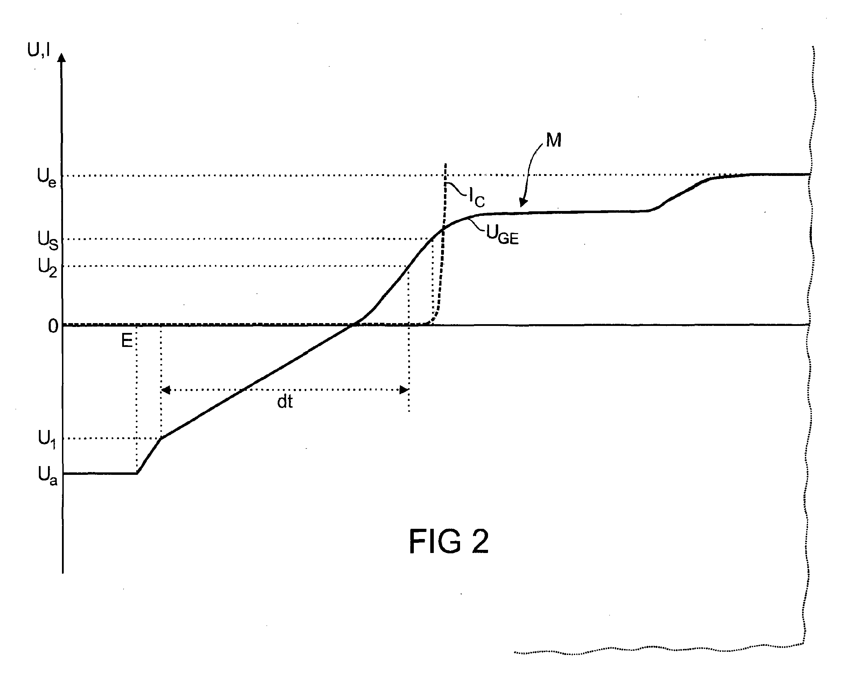

Die erfindungsgemäße Einrichtung 13 weist eine Ansteuerschaltung 3, die zum Einschalten des Halbleiterschalters durch Erhöhen der Gate-Emitter-Spannung U_{GE} des Halbleiterschalters 1 über einen mit dem Gatewiderstandsanschluss GA des Halbleiterschalters 1 verbundenen externen elektrischen Widerstand Rₑₓₜ ausgebildet ist. Der Begriff "extern" bringt dabei im Rahmen der vorliegenden Erfindung zum Ausdruck, dass der elektrische Widerstand Rₑₓₜ nicht Bestandteil des Halbleiterschalters 1 ist. Die Ansteuerschaltung 3 dient zur Ansteuerung des Halbleiterschalters 1 und schaltet diesen, entsprechend einem pulsförmigen Signal P, welches von einer Steuerung 10 erzeugt wird, ein und aus. Die Ansteuerschaltung 3 weist eine Spannungsquelle 11 auf die in Abhängigkeit vom Signal P eine Steuerspannung U_{T} erzeugt. Die Ansteuerschaltung 3 und insbesondere die Spannungsquelle 11 ist über den externen elektrischen Widerstand Rₑₓₜ mit dem Gatewiderstandsanschluss GA des Halbleiterschalters 1 elektrisch verbunden. Wenn das Signal P einen Wert von "0" aufweist, dann weist die Steuerspannung U_{T} die negative Spannung Uₐ auf (siehe FIG 2). Entsprechend weist im stationären Zustand die Gate-Emitter-Spannung U_{GE} die negative Spannung Uₐ auf und der Halbleiterschalter 1 ist ausgeschalten, d.h. der elektrische Widerstand zwischen Kollektor C und Emitter E ist hochohmig.

Wenn der Leistungsschalter eingeschaltet werden soll, dann erzeugt die Steuerung 10 einen Wert von "1" für das Signal P. Bei Empfang der positiven Flanke des Signals P, wenn das Signal P von "0" auf "1" geht, springt die Steuerspannung U_{T} von der negativen Spannung Uₐ auf die positive Spannung Uₑ um. Infolge davon wird die parasitäre Gate-Emitter-Kapazität C_{GE} über den elektrisch in Reihe geschalteten externen Widerstand Rₑₓₜ und den integrierten Gatewiderstand R_{Gint} aufgeladen bis über der Gate-Emitter-Kapazität C_{GE} die Spannung Uₑ anliegt. Der dabei entstehende Verlauf der Gate-Emitter-Spannung U_{GE} über der Zeit t ist in FIG 2 dargestellt. Der Zeitpunkt des Umschaltens der Steuerspannung U_{T} von der negativen Spannung Uₐ auf die positive Spannung Uₑ, d.h. der Zeitpunkt wenn das Signal P von "0" auf "1" geht, stellt den Beginn E der Erhöhung der Gate-Emitter-Spannung und damit den Beginn des Einschaltvorgangs des Halbleiterschalters 1 dar.

Nach Beginn E der Erhöhung der Gate-Emitter-Spannung U_{GE} steigt die Gate-Emitter-Spannung U_{GE}, bis die Schwellspannung U_{S} erreicht ist, schnell an. Wenn die Gate-Emitter-Spannung U_{GE} die Schwellspannung U_{S} überschreitet dann sinkt der elektrische Widerstand zwischen Kollektor K und Emitter E des Halbleiterschalters 1 stark und der Kollektorstrom I_{C} beginnt durch den Halbleiterschalter 1 von Kollektor zum Emitter und von dort zur Last 2 zu fließen. Durch die Rückwirkung der Kollektor-Gate-Kapazität, welche der Übersichtlichkeit halber in FIG 1 nicht dargestellt ist, bildet sich ein sogenanntes Miller-Plateau M im Verlauf der Gate-Emitter-Spannung U_{GE} aus in dem die Gate-Emitter-Spannung U_{GE} nur schwach ansteigt eventuell sogar etwas abfällt, bevor sie nach dem Miller-Plateau M wieder stärker ansteigend die positive Spannung Uₑ erreicht.

Der Verlauf der Gate-Emitter-Spannung U_{GE} im Bereich zwischen dem Beginn E und dem Erreichen der Schwellspannung U_{S} ist stark abhängig vom elektrischen Widerstand des integrierten Gatewiderstands R_{Gint}. Je größer der elektrische Widerstand des integrierten Gatewiderstand R_{Gint} ist, desto flacher ist der Verlauf der Gate-Emitter-Spannung U_{GE} im Bereich zwischen dem Beginn E und dem Erreichen der Schwellspannung U_{S}. Die durchschnittliche Steigung der Gate-Emitter-Spannung U_{GE} im Bereich zwischen dem Beginn E und dem Erreichen der Schwellspannung U_{S} sinkt mit Ansteigen des elektrischen Widerstands des integrierten Gatewiderstand R_{Gint}.

Der elektrische ohmsche Widerstand des integrierten Gatewiderstand R_{Gint} ist temperaturabhängig und erhöht sich mit zunehmender Temperatur des Gatewiderstands R_{Gint} und folglich mit zunehmender Temperatur des Halbleiterschalters. Infolge davon steigt die Gate-Emitter-Spannung U_{GE} im Bereich zwischen dem Beginn E und dem Erreichen der Schwellspannung U_{S} umso langsamer an je höher die Temperatur des Halbleiterschalters ist. Dieser Effekt wird erfindungsgemäß dazu benutzt die Temperatur des Halbleiterschalters zu ermitteln. Da der integrierte Gatewiderstand R_{Gint} in unmittelbarer Nähe der Sperrschicht des Halbleiterschalters, an der ein wesentlicher Teil der im Betrieb des Halbleiterschalters endstehenden Verlustenergie des Halbleiterschalters in Wärme umgesetzt wird, angeordnet ist, folgt die Temperatur des Gatewiderstands R_{Gint} und damit der elektrische Widerstand des Gatewiderstand R_{Gint} hochdynamisch der Temperatur der Sperrschicht des Halbleiterschalters 1. Somit wird durch die Erfindung eine hochdynamische Temperaturermittlung des Halbleiterschalters 1 ermöglicht.

Zur Ermittlung der Temperatur des Halbleiterschalters wird an eine Zeitdauerermittlungseinheit 14, die zur Ermittlung der Zeitdauer dt, die die Gate-Emitter-Spannung U_{GE} während der Erhöhung der Gate-Emitter-Spannung des Halbleiterschalters benötigt um von einer ersten Spannung U₁ auf eine zweite Spannung U₂ anzusteigen (siehe FIG 2), ausgebildet ist, als Eingangsgröße übermittelt. Die Zeitdauerermittlungseinheit 14 weist im Rahmen des Ausführungsbeispiels einen ersten Grenzwertmelder 4, einen zweiten Grenzwertmelder 5, einen Zähler 6 und einen Taktgeber 15 auf. Die Gate-Emitter-Spannung U_{GE} wird dem ersten und zweiten Grenzwertmelder als Eingangsgröße zugeführt. Wenn die Gate-Emitter-Spannung U_{GE} die vorgebende erste Spannung U₁ erreicht, erzeugt der erste Grenzwertmelder 4 ein Signal S1 und übermittelt dieses an einen Zähler 6. Wenn die Gate-Emitter-Spannung U_{GE} die vorgebende zweite Spannung U₂ erreicht, erzeugt der zweite Grenzwertmelder 5 ein Signal S2 und übermittelt dieses an einen Zähler 6. Der Zähler 6 empfängt einen hochfrequenten äquidistanten Takt F, welcher von dem Taktgeber 15 erzeugt wird. Bei Empfang des Signals S1 zählt der Zähler 6 die Anzahl der vom Taktgeber 15 seit Empfang des Signals S1 erzeugten Takte bis er das Signal S2 empfängt. Der Zähler ermittelt somit die Zeitdauer dt, die die Gate-Emitter-Spannung U_{GE} des Halbleiterschalters 1 benötigt um von der ersten Spannung U₁ auf die zweite Spannung U₂ anzusteigen, in Form der Anzahl der vom Taktgeber 15 seit Empfang des Signals S1 bis zum Empfang des Signals S2 erzeugten Takte.

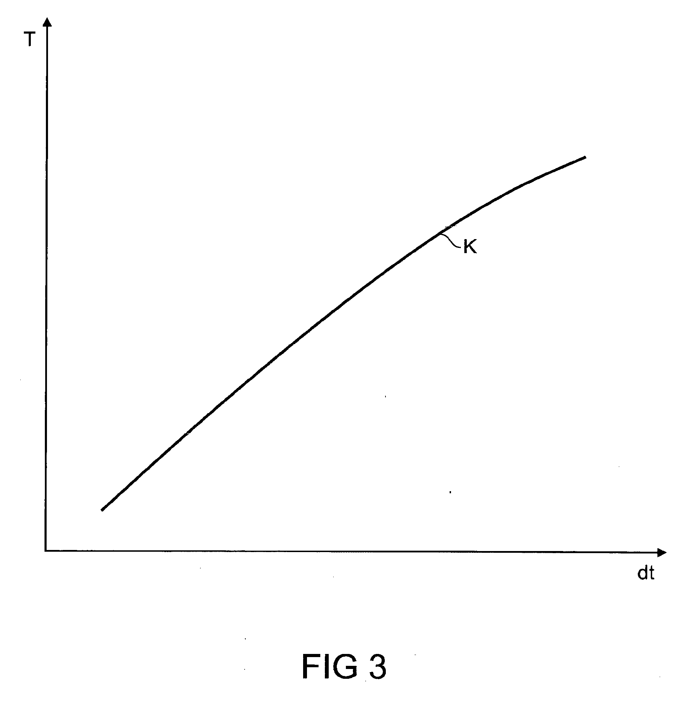

Die Zeitdauer dt wird anschließend als Eingangsgröße an eine Temperaturermittlungseinheit 7, die zur Ermittlung der Temperatur T des Halbleiterschalters 1 anhand der ermittelten Zeitdauer dt ausgebildet ist, übermittelt. Die Temperaturermittlungseinheit 7 ermittelt im Rahmen des Ausführungsbeispiels, anhand der Temperaturkennlinie K des Halbleiterschalters 1 (siehe FIG 3), die die Abhängigkeit der Temperatur T des Halbleiterschalters 1 von der Zeitdauer dt, die die Gate-Emitter-Spannung U_{GE} des Halbleiterschalters 1 benötigt um von der ersten Spannung U₁ auf die zweite Spannung U₂ anzusteigen, angibt, die Temperatur T des Halbleiterschalters 1. Die Temperaturkennlinie K des Halbleiterschalters 1 kann z.B. empirisch ermittelt werden.

Im Rahmen des Ausführungsbeispiels wird die ermittelte Temperatur T des Halbleiterschalters 1 einer Überwachungseinheit 8 als Eingangsgröße übermittelt. Die Überwachungseinheit 8 ist zum Ausschalten des Halbleiterschalters 1, wenn die ermittelte Temperatur T des Halbleiterschalters 1 einen vorgegebenen Temperaturgrenzwert T_{K} erreicht oder überschreitet, ausgebildet. Die Überwachungseinheit 8 erzeugt hierzu im Rahmen des Ausführungsbeispiels, wenn die ermittelte Temperatur T des Halbleiterschalters 1 einen vorgegebenen Temperaturgrenzwert T_{K} erreicht oder überschreitet, bis zu einem Zurücksetzten der Überwachungseinheit 8, ein dauerhaft anstehendendes Ausschaltsignal A und übermittelt dieses als Eingangsgröße an die Ansteuerschaltung 3, die bei Empfang des Ausschaltsignals A solange das Ausschaltsignal A ansteht bis die negative Spannung Uₐ unabhängig vom Pulssignal P erzeugt und somit den Halbleiterschalters 1 dauerhaft ausschaltet. Parallel hierzu wird das Ausschaltsignal A von der Überwachungseinheit 8 an die Steuerung 10 übermittelt, die dem Anwender eine entsprechende Störmeldung anzeigt.

Im Rahmen des Ausführungsbeispiels ist in FIG 1 nur ein einziger Halbleiterschalter dargestellt und mit der erfindungsgemäßen Einrichtung 13 verbunden. Selbstverständlich können aber auch, z.B. wenn mehrere Halbleiterschalter parallel und/oder in Reihe zu einem sogenannten Ventil geschaltet sind, alle oder ein Teil der Halbleiterschalter aus denen das Ventil aufgebaut ist, mit einer jeweilig zugehörigen erfindungsgemäßen Einrichtung 13 elektrisch verbunden sein. In diesem Fall sind die Gateanschlüsse der der jeweilig zugehörigen Einrichtung 13 zugeordneten Halbleiterschalter mit dem externen Widerstand Rext, der jeweilig zugehörigen Einrichtung 13, elektrisch verbunden.

Es sei an dieser Stelle angemerkt, dass die Ansteuerschaltung 12 und der externe Widerstand Rext Bestandteil einer sogenannten Treiberschaltung 12 sein können.

Zur Realisierung der Erfindung ist es lediglich notwendig, anstatt Halbleiterschalter die keinen integrierten Gatewiderstand aufweisen, Halbleiterschalter, die einen integrierten Gatewiderstand aufweisen, zur Realisierung der gewünschten, z.B. leistungselektronischen Schaltung (z.B. Gleichrichter, Wechselrichter etc.) zu verwenden.

## Patentansprüche

1. Verfahren zur Ermittlung der Temperatur (T) eines Halbleiterschalters (1), der einen integrierten elektrischen Gatewiderstand (R_{Gint}) aufweist, mit folgenden Verfahrensschritten:
- Einschalten des Halbleiterschalters (1) durch Erhöhen der Gate-Emitter-Spannung (U_{GE}) des Halbleiterschalters (1) über einen mit dem Gatewiderstandsanschluss (GA) des Halbleiterschalters (1) verbundenen externen elektrischen Widerstand (Rₑₓₜ), **dadurch gekennzeichnet, dass** es weiter die folgenden Verfahrensschritte umfasst:
- Ermittlung der Zeitdauer (dt), die die Gate-Emitter-Spannung (U_{GE}) während der Erhöhung der Gate-Emitter-Spannung (U_{GE}) des Halbleiterschalters (1) benötigt um von einer ersten Spannung (U₁) auf eine zweite Spannung (U₂) anzusteigen und
- Ermittlung der Temperatur (T) des Halbleiterschalters (1) anhand der ermittelten Zeitdauer (dt).

2. Verfahren nach einem der vorhergehenden Ansprüche mit folgenden weiteren Verfahrensschritt:
- Ausschalten des Halbleiterschalters (1) wenn die ermittelte Temperatur (T) des Halbleiterschalters (1) einen Temperaturgrenzwert (T_{K}) erreicht oder überschreitet.

3. Verfahren nach einem der vorhergehenden Ansprüche, **dadurch gekennzeichnet, dass** die zweite Spannung (U₂) unterhalb der Schwellspannung (U_{S}) des Halbleiterschalters (1) liegt.

4. Verfahren nach einem der vorhergehenden Ansprüche, **dadurch gekennzeichnet, dass** der Halbleiterschalter (1) als IGBT oder MOSFET ausgebildet ist.

5. Einrichtung zur Ermittlung der Temperatur (T) eines Halbleiterschalters (1), der einen integrierten elektrischen Gatewiderstand (R_{Gint}) aufweist, umfassend
- eine Ansteuerschaltung (3), die zum Einschalten des Halbleiterschalters (1) durch Erhöhen der Gate-Emitter-Spannung (U_{GE}) des Halbleiterschalters (1) über einen mit dem Gatewiderstandsanschluss (GA) des Halbleiterschalters (1) verbundenen externen elektrischen Widerstand (Rₑₓₜ) ausgebildet ist, **gekennzeichnet durch** eine Zeitdauerermittlungseinheit (14), die zur Ermittlung der Zeitdauer (dt), die die Gate-Emitter-Spannung (U_{GE}) während der Erhöhung der Gate-Emitter-Spannung (U_{GE}) des Halbleiterschalters (1) benötigt um von einer ersten Spannung (U₁) auf eine zweite Spannung (U₂) anzusteigen, ausgebildet ist und
- eine Temperaturermittlungseinheit (14), die zur Ermittlung der Temperatur (T) des Halbleiterschalters (1) anhand der ermittelten Zeitdauer (dt) ausgebildet ist.

6. Schaltungsanordnung mit einer Einrichtung (13) nach Anspruch 6, wobei die Schaltungsanordnung einen Halbleiterschalter (1) aufweist, der einen integrierten elektrischen Gatewiderstand (R_{Gint}) aufweist, wobei die Ansteuerschaltung (3) der Einrichtung (13) über den externen elektrischen Widerstand (Rₑₓₜ) mit dem Gatewiderstandsanschluss (GA) des Halbleiterschalters (1) elektrisch verbunden ist, wobei die Zeitdauerermittlungseinheit (14) mit dem Gatewiderstandsanschluss (GA) des Halbleiterschalters (1) elektrisch verbunden ist.

## Claims

1. A method for determining the temperature (T) of a semiconductor switch (1), which has an integrated electrical gate resistor (R_{Gint}), with the following method steps:
- switching on the semiconductor switch (1) by increasing the gate emitter voltage (U_{GE}) of the semiconductor switch (1) by means of an external electrical resistor (Rₑₓₜ) connected to the gate resistor connection (GA) of the semiconductor switch (1), **characterised in that** it further comprises the following method steps:
- determining the time (dt) that the gate emitter voltage (U_{GE}) requires during the increase of the gate emitter voltage (U_{GE}) of the semiconductor switch (1) in order to increase from a first voltage (U₁) to a second voltage (U₂) and
- determining the temperature (T) of the semiconductor switch (1) on the basis of the time (dt) determined.

2. The method according to one of the preceding claims, with the following further method step:
- switching off the semiconductor switch (1) when the determined temperature (T) of the semiconductor switch (1) reaches or exceeds a temperature limit value (T_{K}).

3. The method according to one of the preceding claims, **characterised in that** the second voltage (U₂) lies below the threshold voltage (Uₛ) of the semiconductor switch (1).

4. The method according to one of the preceding claims, **characterised in that** the semiconductor switch (1) is constructed as an IGBT or MOSFET.

5. An apparatus for determining the temperature (T) of a semiconductor switch (1), which has an integrated electrical gate resistor (R_{Gint}), comprising
- a control circuit (3), which is constructed for switching on the semiconductor switch (1) by increasing the gate emitter voltage (U_{GE}) of the semiconductor switch (1) by means of an external electrical resistor (Rₑₓₜ) connected to the gate resistor connection (GA) of the semiconductor switch (1), **characterised by**
- a time determining unit (14), which is constructed for determining the time (dt) that the gate emitter voltage (U_{GE}) requires during the increase of the gate emitter voltage (U_{GE}) of the semiconductor switch (1) in order to increase from a first voltage (U₁) to a second voltage (U₂), and
- a temperature determining unit (14), which is constructed for determining the temperature (T) of the semiconductor switch (1) on the basis of the time (dt) determined.

6. A circuit arrangement with an apparatus (13) according to Claim 6, wherein the circuit arrangement has a semiconductor switch (1), which has an integrated electrical gate resistor (R_{Gint}), wherein the control circuit (3) of the apparatus (13) is electrically connected to the gate resistor connection (GA) of the semiconductor switch (1) by means of the external electrical resistor (Rₑₓₜ), wherein the time determination unit (14) is electrically connected to the gate resistor connection (GA) of the semiconductor switch (1).

## Revendications

1. Procédé de détermination de la température (T) d'un interrupteur à semi-conducteur (1) comportant une résistance électrique de grille (R_{Gint}) intégrée, comprenant les étapes suivantes :
- activation de l'interrupteur à semi-conducteur (1) par élévation de la tension grille-émetteur (U_{GE}) de l'interrupteur à semi-conducteur (1) au moyen d'une résistance électrique externe (Rₑₓₜ) reliée à la connexion de résistance de grille (GA) de l'interrupteur à semi-conducteur (1), **caractérisé en ce qu'**il comprend en outre les étapes suivantes :
- détermination de la durée (dt) exigée par la tension grille-émetteur (U_{GE}) pour monter d'une première tension (U₁) à une deuxième tension (U₂) pendant l'élévation de la tension grille-émetteur (U_{GE}) de l'interrupteur à semi-conducteur (1), et
- détermination de la température (T) de l'interrupteur à semi-conducteur (1) à partir de la durée (dt) déterminée.

2. Procédé selon l'une des revendications précédentes, comprenant en outre les étapes suivantes :
- désactivation de l'interrupteur à semi-conducteur (1) quand la température (T) déterminée pour l'interrupteur à semi-conducteur (1) atteint ou dépasse une valeur limite de température (T_{K}).

3. Procédé selon l'une des revendications précédentes, **caractérisé en ce que** la deuxième tension (U₂) est inférieure à la tension de seuil (U_{S}) de l'interrupteur à semi-conducteur (1).

4. Procédé selon l'une des revendications précédentes, **caractérisé en ce que** l'interrupteur à semi-conducteur (1) est réalisé comme IGBT ou MOSFET.

5. Dispositif pour la détermination de la température (T) d'un interrupteur à semi-conducteur (1) comportant une résistance électrique de grille (R_{Gint}) intégrée, comprenant
- un circuit d'excitation (3), réalisé pour activer l'interrupteur à semi-conducteur (1) par élévation de la tension grille-émetteur (U_{GE}) de l'interrupteur à semi-conducteur (1) au moyen d'une résistance électrique externe (Rₑₓₜ) reliée à la connexion de résistance de grille (GA) de l'interrupteur à semi-conducteur (1), **caractérisé par**
- une unité de détermination de durée (14), réalisée pour déterminer la durée (dt) exigée par la tension grille-émetteur (U_{GE}) pour monter d'une première tension (U₁) à une deuxième tension (U₂) pendant l'élévation de la tension grille-émetteur (U_{GE}) de l'interrupteur à semi-conducteur (1), et
- une unité de détermination de température (14), réalisée pour déterminer la température (T) de l'interrupteur à semi-conducteur (1) à partir de la durée (dt) déterminée.

6. Montage avec un dispositif (13) selon la revendication 6, ledit montage comportant un interrupteur à semi-conducteur (1) pourvu d'une résistance électrique de grille (R_{Gint}) intégrée, le circuit d'excitation (3) du dispositif (13) étant électriquement relié par la résistance électrique externe (Rₑₓₜ) à la connexion de résistance de grille (GA) de l'interrupteur à semi-conducteur (1), l'unité de détermination de durée (14) étant électriquement reliée à la connexion de résistance de grille (GA) de l'interrupteur à semi-conducteur (1).
